Europäisches Patentamt

European Patent Office

Office européen des brevets

(19)

(11) Numéro de publication : **0 021 894**
**B1**

(12) **FASCICULE DE BREVET EUROPÉEN**

(45) Date de publication du fascicule du brevet :
17.10.84

(51) Int. Cl.³ : **H 05 K 13/06**

(21) Numéro de dépôt : 80400764.9

(22) Date de dépôt : 29.05.80

(54) Procédé et dispositif d'interconnexions de composants électroniques.

(30) Priorité : 07.06.79 FR 7914592

(43) Date de publication de la demande :
07.01.81 Bulletin 81/01

(45) Mention de la délivrance du brevet :
17.10.84 Bulletin 84/42

(84) Etats contractants désignés :
**CH DE GB IT LI**

(56) Documents cités :
FR-A- 2 084 258
FR-A- 2 191 399
US-A- 3 786 172
US-A- 3 842 190

(73) Titulaire : **COMMISSARIAT A L'ENERGIE ATOMIQUE**
**Etablissement de Caractère Scientifique Technique**
**et Industriel**
**B.P. 510**
**F-75752 Paris Cedex 15 (FR)**

(72) Inventeur : **Nicolas, Gérard**
**"Les Tilleuls"**
**F-38340 Voreppe (FR)**
Inventeur : **Ponthenier, Gérard**
**"Le Piollier" Champagnier**
**F-38800 Le Pont de Claix (FR)**
Inventeur : **Turc, Gérard**
**7, rue de l'Ecureuil**
**F-38130 Echirolles (FR)**

(74) Mandataire : **Mongrédien, André et al**
**c/o BREVATOME 25, rue de Ponthieu**
**F-75008 Paris (FR)**

## Description

La présente invention concerne un procédé de réalisation d'un circuit d'interconnexions électriques pour composants électroniques, ainsi qu'un dispositif pour la mise en œuvre de ce procédé.

Les composants électroniques miniaturisés sont généralement fixés sur un support de base isolant sur lequel sont réalisées les différentes interconnexions électriques entre ces composants. Afin de profiter au mieux de la miniaturisation croissante des composants électroniques, il est nécessaire de disposer un nombre maximum de composants sur une surface du support de base aussi petite que possible. Ce résultat ne peut être obtenu qu'en miniaturisant les connexions électriques et en utilisant des fils isolés dont la mise en place peut être effectuée automatiquement et dont le tracé peut être modifié à la demande.

On connaît un certain nombre de procédés et de dispositifs permettant de réaliser automatiquement et selon des tracés programmables les circuits d'interconnexions électriques entre différents composants électroniques. Cependant, ces dispositifs connus sont généralement complexes lorsqu'ils permettent d'obtenir une miniaturisation convenable des circuits d'interconnexions, alors que les dispositifs plus simples ne permettent pas d'obtenir une densité de composants satisfaisante en tenant compte de la miniaturisation de ceux-ci.

On connaît déjà du document FR-A-2 191 399 un tel procédé selon lequel on utilise un support de base isolant comportant des zones conductrices, on réunit les zones à interconnecter par un fil isolé thermosoudable en le collant sur le support de base, on soude le fil dénudé sur les zones conductrices, et on le coupe après soudure. Ce procédé présente l'avantage de réaliser tardivement le dépôt des fils d'interconnexion, ce qui permet de modifier le circuit d'interconnexions à la demande à partir de cartes standardisées préparées à l'avance.

On connaît aussi du document US-A-3 842 190 un procédé pour réaliser des interconnexions au moyen d'un fil isolé dont les extrémités sont soudées à des zones conductrices présentant chacune une partie destinée à recevoir le fil soudé et une partie susceptible de contacter une patte d'un composant électronique.

Par ailleurs, on connaît également un dispositif qui réalise le circuit d'interconnexions électriques au moyen d'un fil isolé thermosoudable permettant à la fois de limiter l'encombrement des interconnexions en autorisant leurs croisements grâce à l'isolement du fil, tout en évitant d'avoir recours à un dispositif annexe pour dénuder le fil, puisque celui-ci est dénudé et soudé simultanément au moyen d'un fer à souder. Cependant, en raison de la double fonction du fer et du contact linéaire entre celui-ci et le fil à souder, le chauffage doit durer pendant un temps relativement long afin de provoquer la sublimation complète du vernis polyuréthane qui constitue généralement l'isolant entourant le fil, et la fusion de la couche d'étain plomb déposée sur la pastille conductrice afin de réaliser la soudure. Il en résulte que la soudure doit être effectuée sur une pastille conductrice de dimensions relativement importantes (de l'ordre de 2 mm de diamètre), afin que cette durée de chauffage n'ait pas de conséquences dommageables telles que le décollement et la dégradation de la pastille. L'encombrement du circuit d'interconnexions obtenu avec un tel dispositif n'est donc pas suffisamment réduit pour permettre une utilisation optimum des composants électroniques miniaturisés disponibles actuellement, et ce dispositif ne convient donc pas à un procédé de réalisation automatique du circuit d'interconnexions électriques entre ces composants.

Afin de remédier aux inconvénients de ce dispositif connu, et conformément à une première caractéristique de l'invention, il est proposé un procédé de réalisation d'un circuit d'interconnexions électriques sur un support de base isolant comportant des zones conductrices susceptibles de recevoir des composants électroniques, dans lequel on réunit les zones à interconnecter par un fil isolé thermosoudable que l'on coupe après soudure, ce procédé étant caractérisé en ce qu'on dépose du flux liquide sur les parties du fil à souder reposant sur les zones conductrices avant de réaliser la soudure, afin de diminuer le temps de chauffage.

En raison de l'utilisation d'un fil thermosoudable, l'invention permet de se passer d'une opération distincte d'étamage du fil isolé.

De plus, en raison de l'apport de flux préalable à la soudure, l'invention permet de diminuer sensiblement le temps de chauffage, la chaleur induite par le fer étant communiquée très rapidement à toute la surface externe du fil et à la surface adjacente de la pastille conductrice, ce qui permet d'effectuer dans la même opération le dénudage du fil ainsi que d'accélérer la fusion de la couche d'étain plomb déposée sur la pastille conductrice afin de réaliser la soudure, tout en limitant l'oxydation du fil dénudé et de l'étain. Les dimensions de la pastille conductrice peuvent donc être sensiblement réduites par rapport aux dimensions des pastilles utilisées dans le dispositif antérieur connu utilisant un fil isolant thermosoudable.

Conformément à une deuxième caractéristique de l'invention, l'extrémité non soudée du fil coupé est saisie et amenée sur une zone conductrice afin de débuter une autre interconnexion. Cette caractéristique permet de réaliser un positionnement précis et un maintien du fil par rapport à la pastille conductrice sur laquelle il doit être soudé.

Conformément à une troisième caractéristique de l'invention, le support de base isolant comportant des groupes de zones conductrices alignées susceptibles de recevoir des boîtiers électroniques munis de deux séries de pattes alignées et les zones conductrices comprenant des pastilles définissant chacune un plot de raccordement susceptible de recevoir une patte d'un boîtier, et une zone de soudage de fils juxtaposée au plot de raccordement, le plot de raccordement et la zone de soudage de fils sont arrangés dans la direction définie par le groupe de zones conductrices correspondant, chaque pastille étant découpée de façon à présenter une zone de largeur réduite jouant le rôle d'une résistance thermique entre le plot de raccordement et la zone de soudage. On évite ainsi l'écoulement de l'étain plomb dans le trou destiné à recevoir la patte du boîtier, celui-ci n'étant pas encore monté lors du soudage. De plus, cette caractéristique permet de maintenir le fil soudé en place en cas de refusion de l'étain. Chaque pastille peut également être contenue dans un carré dont le côté est sensiblement égal aux 3/5e de la distance séparant le centre de deux zones conductrices successives d'un même groupe, le plot de raccordement et la zone de soudage occupant dans ce carré deux rectangles juxtaposés dont les surfaces respectives sont sensiblement égales à 2/3 et à 1/3 de la surface totale du carré. Ces différentes caractéristiques permettent de réaliser des pastilles de soudage de dimensions particulièrement réduites, dont l'utilisation ne serait pas possible si du flux liquide n'était pas déposé sur le fil isolé thermosoudable avant de réaliser la soudure. La forme et la disposition précitées de ces pastilles participent donc à la miniaturisation du circuit d'interconnexions dans le procédé selon l'invention.

L'invention concerne également un perfectionnement à un dispositif pour la réalisation d'un circuit d'interconnexions électriques pour composants électroniques, ayant pour fonction de relier par des fils isolés des zones conductrices situées sur un support de base éventuellement recouvert de résine adhésive en dehors desdites zones conductrices, ce dispositif comprenant une table XY, le support de base isolant étant solidaire de ladite table, des moyens pour commander les translations de ladite table XY suivant les deux directions perpendiculaires, une tête constituée d'un fût fixe et d'un bâti rotatif lié au fût, des moyens pour commander la rotation du bâti autour d'un axe perpendiculaire au support, des moyens solidaires du fût fixe pour dérouler un fil thermosoudable, et des moyens solidaires du bâti rotatif pour appliquer le fil sur le support, dénuder et souder le fil sur les zones conductrices et couper le fil après soudure, ce perfectionnement étant caractérisé en ce que la tête porte-outil porte de plus des moyens pour déposer sur le fil à souder reposant sur une zone conductrice une quantité déterminée de flux à souder.

Dans un mode de réalisation préféré de l'invention, les moyens pour déposer une quantité déterminée de flux à souder comprennent un bras mobile muni d'une extrémité recourbée et un réservoir de flux à niveau constant dans lequel l'extrémité recourbée du bras est au repos en contact permanent avec le flux.

Selon une autre caractéristique de l'invention, le dispositif défini précédemment comprend de plus des moyens pour saisir l'extrémité non soudée du fil coupé. De préférence, ces moyens comprennent une pince et les moyens pour couper le fil comprennent un couteau, la pince étant portée par le couteau et munie d'une extrémité recourbée mobile dans une direction normale au support de base par rapport au couteau, le déplacement de l'extrémité recourbée de la pince par rapport au couteau commandant l'ouverture et la fermeture de la pince. Dans un mode de réalisation particulier de l'invention, l'extrémité recourbée de la pince fait saillie au-delà du tranchant du couteau lorsque la pince est ouverte, de telle sorte que la mise en œuvre du couteau entraîne la venue en butée de l'extrémité recourbée de la pince contre le support de base, puis le déplacement du couteau par rapport à l'extrémité de la pince dans le sens correspondant à la fermeture de celle-ci. Dans ce mode de réalisation particulier de l'invention, les moyens pour dénuder et souder le fil comprennent une butée susceptible de venir affleurer une butée en vis-à-vis formée sur la pince lors de leur mise en œuvre, de telle sorte que le déplacement du couteau en éloignement du support de base entraîne la venue en butée de la pince contre la butée formée sur les moyens pour dénuder et souder le fil, puis le déplacement du couteau par rapport à l'extrémité de la pince dans le sens correspondant à l'ouverture de celle-ci. Ainsi, l'extrémité de la pince peut comprendre deux mors en vis-à-vis sollicités élastiquement en éloignement l'un de l'autre et définissant sur leurs bords opposés des surfaces de came avec lesquelles coopèrent des doigts fixés rigidement au couteau, la forme des surfaces de came étant telle que la pince est ouverte lorsque son extrémité fait saillie au-delà du tranchant du couteau et fermée lorsque son extrémité est sensiblement alignée avec le tranchant du couteau. De préférence, la pince est alors réalisée en un fil élastique préformé, tel qu'une corde à piano, replié en forme de U pour définir les mors de la pince par ses deux extrémités en forme de losange, le fil élastique étant fixé au couteau par sa partie médiane, les doigts fixés au couteau coopérant avec les mors au voisinage de l'angle aigu du losange opposé à l'extrémité de la pince, lorsque celle-ci fait saillie au-delà du tranchant du couteau, et coopérant avec les mors au voisinage des angles obtus du losange, et du côté de l'extrémité de la pince lorsque celle-ci est sensiblement alignée avec le tranchant du couteau.

On décrira maintenant, à titre d'exemple non limitatif, un mode de réalisation particulier de l'invention en se référant aux dessins annexés, dans lesquels :

la figure 1 est une vue en perspective représentant une fraction d'un support de base isolant comprenant des groupes de pastilles conductrices alignées interconnectées par un circuit électrique conformément au procédé selon l'invention, ces pastilles s'apprêtant à recevoir les pattes alignées d'un composant tel qu'un boîtier électronique ;

la figure 2 est une vue agrandie représentant l'une des pastilles conductrices et sa fixation sur le support de base isolant représenté sur la figure 1 ;

la figure 3 est une vue en coupe représentant de façon schématique un dispositif pour la réalisation du circuit d'interconnexions électriques représenté sur la figure 1, ce dispositif étant conforme aux enseignements de la présente invention ;

la figure 4 est une vue en perspective représentant certains des outils portés par le dispositif représenté sur la figure 3, et notamment un fer à souder ainsi qu'un ensemble permettant de déposer une quantité déterminée de flux à souder avant la mise en œuvre du fer ;

la figure 5 est une vue en perspective représentant d'autres outils portés par le dispositif représenté sur la figure 3, et notamment un appareil permettant de couper le fil et de saisir l'extrémité non soudée de celui-ci après qu'il ait été coupé ; et

les figures 6a à 6h représentent de façon schématique les différentes étapes de mise en œuvre du dispositif représenté sur les figures 3 à 5.

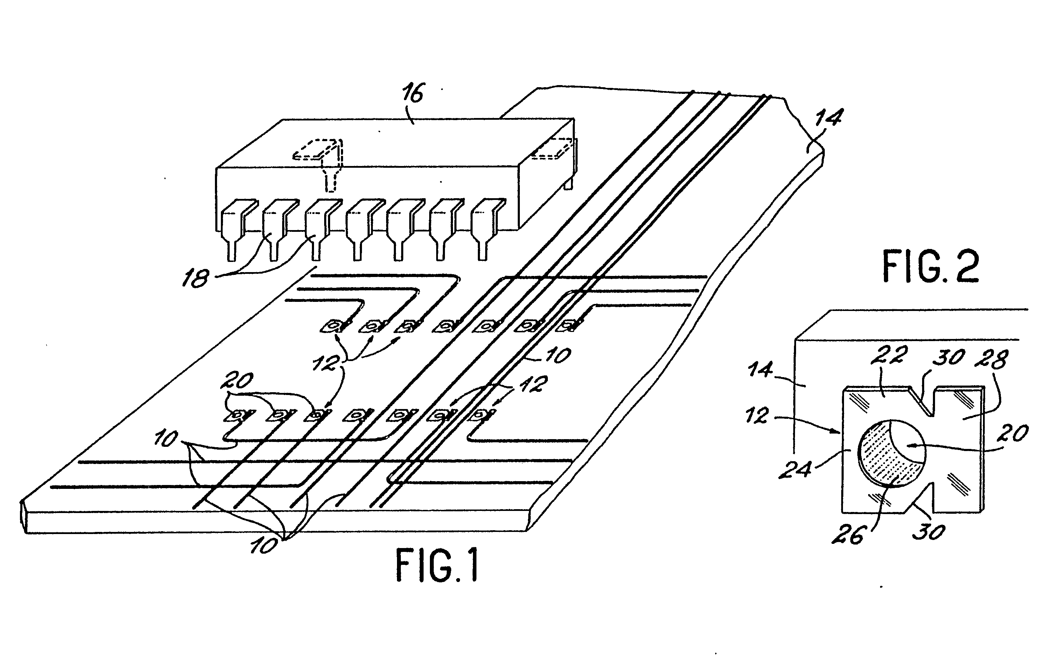

Comme l'illustre la figure 1, l'invention a pour but de permettre la réalisation d'un circuit comprenant un certain nombre d'interconnexions électriques, au moyen de fils de liaison 10 reliant électriquement des zones conductrices 12 fixées sur l'une des faces d'un support de base isolant 14, ce circuit étant susceptible de recevoir un certain nombre de composants électroniques miniaturisés tels que le boîtier 16. Plus précisément, les composants électroniques 16 qui sont prévus pour être montés sur le support 14 comprennent des pattes 18 reçues dans des trous 20 traversant le support 14 et les zones conductrices 12, de façon à permettre la fixation de ces composants, par exemple par soudure, et leur interconnexion selon un circuit électrique défini par avance, par l'intermédiaire des zones conductrices 12 et des fils de liaison 10, ces derniers étant collés sur le support 14 et soudés aux zones 12 avant le montage des composants, selon un procédé qui sera décrit par la suite.

Conformément à l'invention, les fils de liaison 10 sont des fils conducteurs tels que des fils de cuivre isolés et thermosoudables. L'isolant est constitué par exemple par une couche de vernis polyuréthane ayant la propriété de se volatiliser très rapidement, c'est-à-dire en une seconde à 400 °C et en trois secondes à 380 °C.

Afin d'assurer la tenue mécanique des fils 10, une couche d'adhésif thermodurcissable est déposée sur la face du support 14 destinée à recevoir les fils et les composants. Cet adhésif peut être déposé sur toutes les parties non conductrices de cette face par tout moyen connu. Ainsi, il peut s'agir d'un film sec qui adhère sur le support par chauffage, les trous correspondant aux zones conductrices étant faits avant ou après dépôt du film sur le support, par exemple par sérigraphie. La résine peut aussi être déposée en solution, par sérigraphie, ou encore sous forme d'un film continu photosensible gravé par voie chimique, par exemple après insolation des zones à conserver à travers un masque photographique. L'adhésif peut également être radiodurcissable. Il peut ainsi être déposé localement par la machine ou préexister sur le fil.

Afin de permettre la réalisation automatique du circuit d'interconnexions conformément à l'invention, les fils de liaison 10 ne doivent en aucun cas être placés sur les zones conductrices 12 correspondant à des composants électroniques non connectés. En outre, ces fils doivent obligatoirement être disposés soit horizontalement, soit verticalement, soit à 45°, entre les rangées formées par les zones conductrices 12, comme le montre la figure 1.

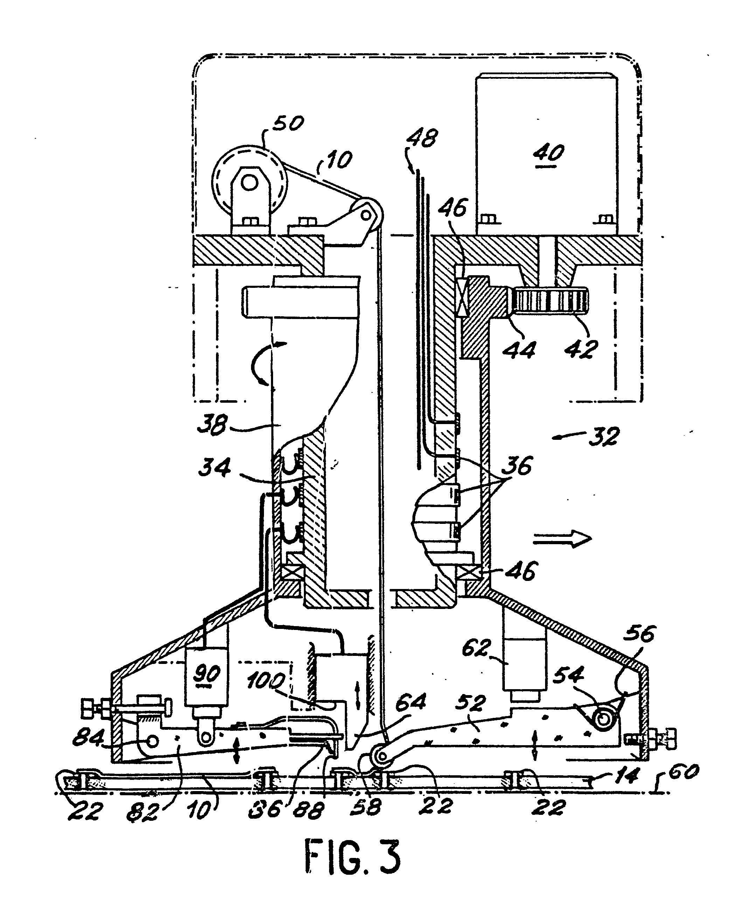

Dans ces conditions, et comme l'illustre en particulier la figure 2, les zones conductrices 12 comprennent chacune une pastille 22 définissant un plot de raccordement 24, et une zone de soudage 28. Les parois du trou 20 destiné à recevoir l'une des pattes 18 du composant 16 sont métallisées comme représenté en 26. La zone de soudage 28 est juxtaposée au plot de raccordement 24 et séparée de ce dernier par des entailles triangulaires opposées 30 définissant entre elles une résistance thermique dont la fonction apparaîtra dans la suite de la description. La pastille 22 est constituée par une couche de cuivre d'environ 35 μ d'épaisseur recouverte d'une couche d'étain-plomb d'au moins 25 μ d'épaisseur qui permet de réaliser le soudage des fils 10 sans apport d'étain.

De préférence, lorsque le support de base 14 comporte des groupes de zones conductrices 12 alignées susceptibles de recevoir des composants électroniques, tels que le boîtier 16, munis de deux séries de pattes alignées 18, la zone de soudage 28 de chacune des pastilles 22 est juxtaposée au plot de raccordement 24 dans la direction définie par le groupe de zones conductrices 12 correspondant, comme l'illustre la figure 1. En outre, chacune des pastilles 22 est contenue dans un carré dont le côté est sensiblement égal aux 3/5 de la distance séparant le centre de deux zones conductrices 12 successives d'un même groupe, le plot de raccordement 24 et la zone de soudage 28 occupant dans ce carré deux rectangles juxtaposés dont les surfaces respectives sont sensiblement égales à 2/3 et à 1/3 de la surface totale du carré comme le montre en particulier la figure 2. En pratique, la distance séparant le centre de deux zones conductrices 12 successives d'un même groupe est normalisée et égale à 2,54 mm, de sorte que la pastille 22 est alors inscrite dans un carré dont le côté est égal à 1,524 mm, ce qui permet alors de faire passer jusqu'à deux fils de liaison 10 entre deux zones conductrices successives 12 d'un même groupe, comme le montre la figure 1, pour un espacement entre fils de 0,508 mm. En travaillant avec un espacement plus faible, 0,254 mm par exemple, on pourrait faire passer trois et même quatre fils.

La structure, la disposition et le dimensionnement des pastilles 22 qui viennent d'être décrits permettent d'améliorer sensiblement la densité de composants sur le support 14, trente boîtiers du type du boîtier 16 pouvant être disposés sur 1 dm² de support.

L'utilisation de pastilles 22 de surface réduite est rendue possible par le procédé de réalisation du circuit d'interconnexion 10 selon l'invention.

Ce procédé met en œuvre un dispositif représenté schématiquement sur la figure 3, qui comprend une tête porte-outils, désignée de façon générale par la référence 32. La tête porte-outils 32 est composée principalement d'un fût central fixe 34 relié électriquement par des contacts tournants 36 à un bâti tournant 38, ce dernier étant mu par un moteur électrique 40 par l'intermédiaire d'un pignon 42 agissant sur une roue dentée 44 solidaire du bâti 38. Le bâti tournant 38 est supporté par le fût central 34 par l'intermédiaire de deux paliers 46. Le fût central 34 porte l'alimentation électrique (non représentée) des différents outils, la tension délivrée arrivant par les fils 48. Le fût 34 porte également un système d'alimentation 50 en fils isolants 10.

Le bâti tournant 38 porte un bras 52, par l'intermédiaire d'un pivot 54 sur lequel est monté un ressort de torsion 56 sollicitant par une roulette 58 montée à l'extrémité libre du bras 52 le fil 10 contre le support 14, ce dernier étant monté sur une table 60. Un électroaimant 62 est susceptible de solliciter le bras 52 vers le haut en considérant la figure 3, de façon à écarter la roulette 58 du support 14 à l'encontre de la force exercée par le ressort 56.

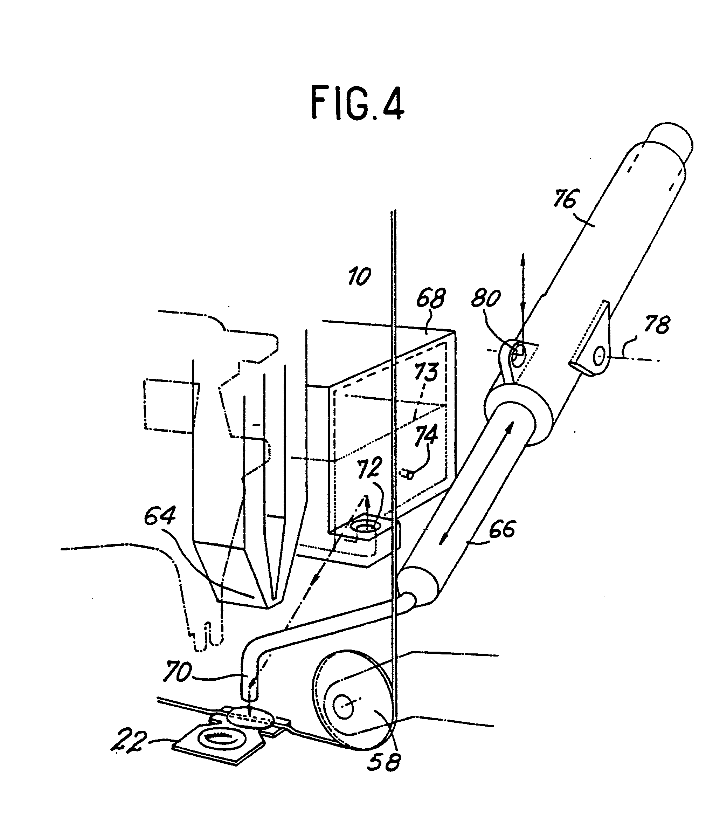

Le bâti tournant 38 porte également un dispositif de soudure comprenant un fer à souder dont la panne 64, représentée en perspective sur la figure 4, est commandée par un dispositif à électroaimant (non représenté) susceptible de la déplacer entre une position relevée (sur la figure 4), et une position de fonctionnement dans laquelle elle est appliquée sur le fil 10. La panne 64 est chauffée directement par conduction et son inertie thermique est aussi faible que possible, de telle sorte que la montée et la descente en température sont très rapides. Le circuit de chauffage (non représenté) est constitué par un transformateur abaisseur de tension permettant d'obtenir au secondaire un très fort courant alternatif sous une basse tension, ce courant traversant directement la panne 64 et sa fréquence étant assez élevée, par exemple de 20 000 Hz, afin de diminuer le volume de l'entrefer. Comme l'illustre en particulier la figure 4, l'extrémité chauffante de la panne 64 est profilée de telle sorte qu'elle présente la plus grande résistance possible. Elle est réalisée en un matériau non étamable, très résistant chimiquement, ne formant pas d'oxyde en-dessous de 400 °C, possédant une bonne conductivité thermique et une bonne capacité calorifique. On utilise de préférence le tungstène ou le molybdène.

Conformément à l'invention, le bâti tournant 38 porte également un dispositif pour déposer sur le fil à souder reposant sur une zone conductrice une quantité déterminée de flux à souder, ou dispositif de fluxage, représenté sur la figure 4. Ce dispositif comprend un bras mobile 66 et un réservoir de flux fermé, à niveau constant 68, le bras 66 présentant une extrémité recourbée 70 qui plonge normalement dans un trou 72 formé à la base du réservoir 68 de façon à être en contact permanent avec le flux 73, dont le niveau est maintenu constant dans le trou 72 au moyen d'un second trou 74 formé dans le réservoir 68 légèrement au-dessus du trou 72. Les dimensions des trous 72 et 74 sont déterminées en fonction du diamètre de l'extrémité 70 du bras 66, de la viscosité du flux 73, de l'épaisseur des parois du réservoir 68 et de la hauteur de liquide dans ce réservoir, de telle sorte que, lorsqu'une quantité déterminée de flux est extraite du réservoir par le trou 72, au moyen d'un bras 66, de l'air entre par le trou 74, qui se trouve sur la paroi verticale du réservoir juste au-dessus du trou 72, de façon à rétablir l'équilibre de pression à l'intérieur du réservoir 68.

Comme l'illustre la figure 4, les déplacements du bras 66 sont commandés dans une direction longitudinale par un premier électroaimant 76, celui-ci étant monté pivotant autour d'un axe 78 de façon à pouvoir basculer sous l'action d'un second électroaimant (non représenté) articulé sur l'électroaimant 76 par sa boutonnière 80. Bien entendu, les déplacements du bras 66 peuvent être commandés d'une manière différente, le mouvement longitudinal de ce bras pouvant par exemple être obtenu par rotation.

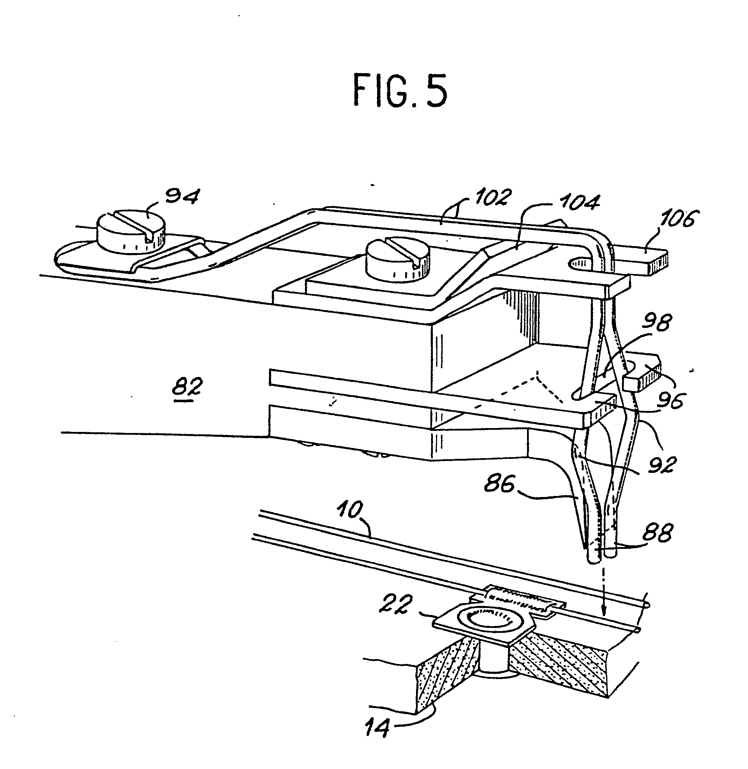

Enfin, comme le montrent la figure 3 et, de façon plus précise, la figure 5, le bâti tournant 38 porte par l'intermédiaire d'un pivot 84, un second bras 82 muni à son extrémité libre d'un couteau 86 et d'une pince 88. Le bras 82 est commandé par un électroaimant 90. Comme l'illustre la figure 5, qui représente l'extrémité libre du bras 82, le couteau 86 est constitué par une lame d'acier dont le tranchant rectiligne lui permet de couper les fils 10 après que ceux-ci aient été soudés sur les pastilles 22.

La pince 88 est réalisée en un fil élastique préformé, tel qu'une corde à piano, replié en forme de U pour définir les mors 92 de la pince par ses deux extrémités, le fil élastique étant fixé au bras 82 dans sa partie médiane par une vis 94. L'extrémité libre du bras 82 porte également de façon rigide deux doigts 96 définissant entre eux une fente 98 dans laquelle sont reçus les mors 92 de la pince 88. Les doigts 96 coopèrent avec des surfaces de came définies sur les bords opposés des mors 92. Ces surfaces de came sont obtenues par le fait que les extrémités du fil définissant la pince 88 sont pliées en forme de losange. Ainsi, la pince est ouverte lorsque les doigts 96 se trouvent au voisinage de l'angle aigu du losange défini par les mors opposés à l'extrémité de la pince 88, et celle-ci fait alors saillie au-delà du tranchant du couteau 86, comme le montre la figure 5. Au contraire, la pince 88 est fermée lorsque son extrémité est sensiblement alignée avec le tranchant du couteau 86, car les doigts 96 coopèrent alors avec les mors 92 au voisinage des angles obtus du losange défini par ces derniers et du côté de l'extrémité de la pince. Comme on le verra par la suite, lorsque la pince est fermée, son ouverture ne peut être obtenue qu'au moyen d'une butée 100 définie sur le fer à souder 64 et susceptible de venir engager une butée correspondante 102 définie sur la partie supérieure de la pince 88 en considérant la figure 5. La venue en contact des butées 100 et 102 permet en effet de solliciter les mors 92 vers le bas par rapport au couteau 86 dans leur position d'ouverture vers laquelle la pince 88 est sollicitée par l'élasticité naturelle du fil qui la constitue. L'extrémité du bras 82 porte en outre une butée 104 contre laquelle vient prendre appui la pince 88 en position ouverte, ainsi qu'un guide 106.

Le dispositif pour la réalisation des interconnexions d'un circuit électrique sur un support de base isolant qui vient d'être décrit en se référant aux figures 3 à 5 fonctionne de la façon suivante.

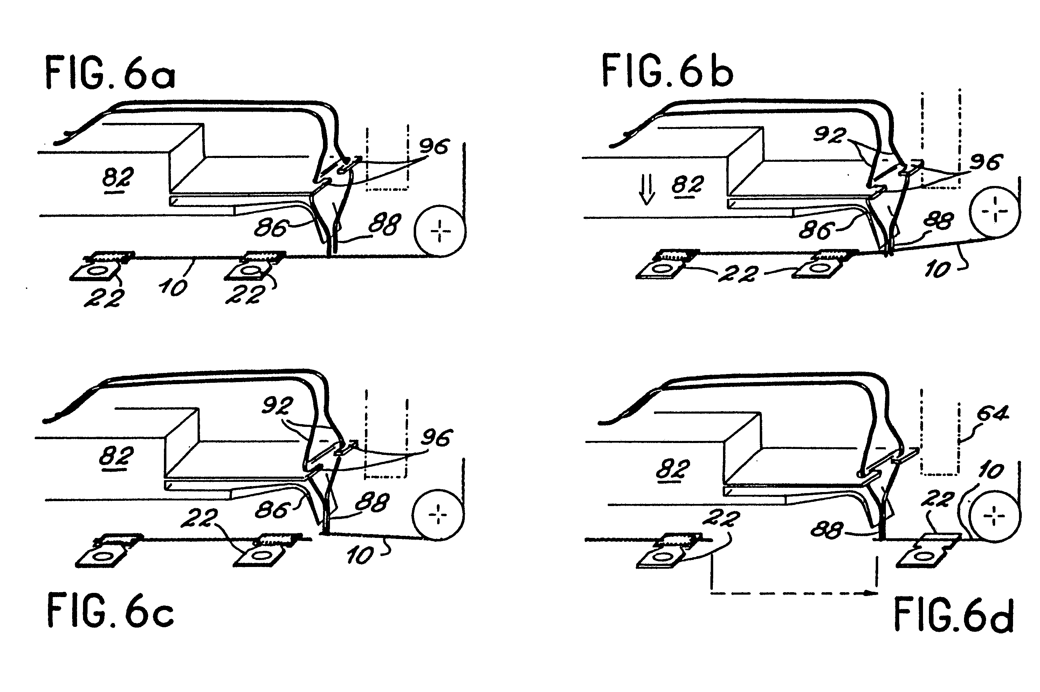

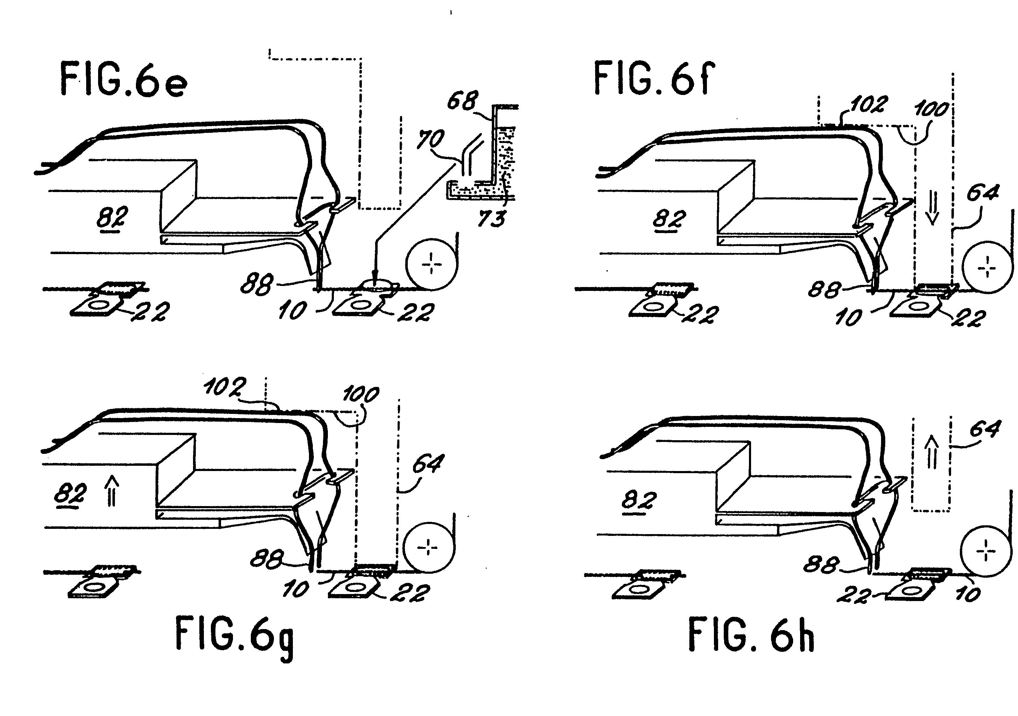

La figure 6a illustre la position occupée par le bras 82 du dispositif 32 après la réalisation d'une interconnexion au moyen du fil 10 entre deux pastilles 22. La roulette 58 s'est levée au droit de la pastille après laquelle on doit couper le fil ; ainsi, le fil n'est pas collé dans la zone de coupe et son inclinaison facilite sa saisie par la pince 88. La pince 88 est alors ouverte comme le montre la figure 5 et son extrémité fait saillie au-delà du tranchant du couteau 86. Afin de couper le fil 10, le bras 82 bascule alors autour du pivot 84 sous l'action de l'électroaimant 90, comme l'illustre la figure 6b, de telle sorte que l'extrémité libre de la pince 88 vient d'abord en butée contre le support 14. Le bras 82 continue à basculer jusqu'à ce que le tranchant du couteau 86 coupe le fil 10, de telle sorte que les doigts 96, fixés rigidement au couteau 86, se déplacent vers le bas par rapport aux mors 92 de la pince 88 comme l'illustrent successivement les figures 6b et 6c. Les extrémités des mors 92 sont donc suffisamment rapprochées l'une de l'autre pour saisir l'extrémité non soudée du fil 10 lorsque celui-ci vient d'être coupé par le couteau 86. La pince 88 est maintenue en position serrée, malgré l'élasticité du fil qui la constitue, par le fait que les doigts 96 sont alors situés légèrement en dessous des angles obtus définis par le losange formé par les mors 92 comme l'illustre la figure 6c.

La connexion qui vient d'être réalisée au moyen du fil 10 est alors totalement terminée et l'extrémité libre de celui-ci est serrée au moyen de la pince 88, ce qui permet de l'amener sur une autre pastille conductrice 22 comme l'illustre la figure 6d. Le déplacement de la tête porte-outils 32 par rapport au support dans un plan parallèle à ce dernier peut être obtenu, soit par déplacement de la table 60, soit par déplacement de la tête porte-outils 32, soit par déplacement combiné de ces deux éléments. De préférence, les mouvements de translation sont effectués au moyen de la table 60, et les mouvements de rotation sont effectués au moyen de la tête pivotante 32.

La figure 6d illustre la position dans laquelle se trouve le fil juste avant que ne débute la réalisation d'une nouvelle interconnexion entre deux pastilles 22. L'extrémité du fil 10 est alors disposée sur la zone de soudage 28 de la pastille 22 correspondante et la panne 64 du fer à souder se trouve située verticalement juste au-dessus de cette zone de soudage, le fil 10 étant maintenu dans cette position au moyen de la pince 88. Conformément à la présente invention, le dispositif de fluxage est alors mis en œuvre, c'est-à-dire que le bras 66 parcourt le chemin représenté en traits mixtes sur la figure 4 entre le trou 72 du réservoir 68 et le fil 10, de façon à verser sur la partie du fil 10 située sur la zone de soudage de la pastille 22 une goutte de flux 73 correspondant à une quantité déterminée, suffisante pour enrober le fil ainsi que la face correspondante de la zone de soudage. Cette opération étant réalisée, le bras 66 retourne dans sa position de repos dans laquelle son extrémité 70 pénètre dans le trou 72, dans lequel le niveau est redevenu identique à ce qu'il était précédemment en raison de la pénétration d'une bulle d'air dans le réservoir fermé 68 par le trou 74.

Le décapage et la soudure proprement dite peuvent alors être effectués en descendant la panne 64 du fer jusqu'à ce qu'elle vienne en contact avec le fil 10 toujours maintenu par la pince 88. Sous l'effet du flux 73 déposé précédemment sur le fil 10 et sur la zone de soudure 28, la chaleur produite par la mise sous tension du fer à souder est communiquée presque instantanément à toute la surface externe du fil 10 et sur la zone de soudure de la pastille 22, de telle sorte que le temps de chauffage permettant à la fois de sublimer la couche de vernis polyuréthane se trouvant à la surface du fil 10 et de souder le fil ainsi dénudé sur la zone de soudure par fusion de la couche d'étain-plomb se trouvant à la surface de celle-ci est très sensiblement diminué par rapport aux procédés antérieurs connus. Ceci permet d'utiliser des pastilles 22 de dimension réduite, telles que celle qui est représentée sur la figure 2, sans risquer de voir celles-ci se décoller ou brûler. La miniaturisation du circuit d'interconnexions et la possibilité de réaliser automatiquement ce circuit sont donc facilitées. En outre, l'utilisation du flux à souder selon l'invention permet de diminuer les phénomènes d'oxydation de l'étain-plomb et du fil de cuivre, ce qui participe à la diminution du temps de chauffage nécessaire à la soudure.

Il convient de noter que ce résultat ne pourrait être obtenu par l'utilisation de pastilles 22, ou tout au moins de zones 28, préalablement recouvertes de flux. En effet, si le flux est déposé préalablement sur les pastilles, il y aura séchage du solvant, il se produira des extraits secs solides et le contact thermique fer-fil-pastille sera mauvais (contact sur une génératrice du fil). Et, même en supposant que le flux prévu reste liquide sur les pastilles, il ne pourrait recouvrir aussi le fil.

Au cours de la réalisation du circuit d'interconnexions électriques sur le support 14, les composants tels que le boîtier 16 ne sont pas encore montés. Les trous 20 nécessaires au passage des pattes 18 de ces composants ne sont donc pas bouchés, de telle sorte que l'étain risque de couler dans ces trous pendant la phase de soudure. Ce risque est accentué par la petite taille des pastilles 22 autorisée par l'invention. Il est cependant évité dans la pastille représentée sur la figure 2, par la réalisation d'une résistance thermique entre la zone de soudage 28 et le plot de raccordement 24, au moyen des entailles triangulaires 30. Cette résistance thermique permet en outre de maintenir le fil sur la zone de soudage 28 lorsque la soudure doit subir une refusion, et particulièrement lors d'une soudure « à la vague ». Cette soudure est utilisée lorsque le circuit, une fois câblé et soudé par la machine, est ensuite équipé de composants (boîtiers par exemple) pour souder ces composants au circuit. Les pattes de ces composants sont alors soudées à l'étain dans les trous des pastilles, de façon collective, en faisant « lécher » une face de la carte (la face opposée aux composants) par une vague d'étain-plomb en fusion. C'est ainsi que les soudures des fils peuvent être refondues, et il faut alors que les fils restent en place.

La durée relativement courte du chauffage est déterminée non pas par une manœuvre mécanique extrêmement rapide du fer à souder, mais par une mise sous tension extrêmement brève de celui-ci. Ainsi, lorsque la soudure est terminée, le fer 64 est maintenu dans la position basse représentée sur la figure 6f, dans laquelle la butée 100 formée sur le fer à souder affleure la butée 102 formée sur la pince 88. L'ouverture de la pince 88 est alors obtenue en maintenant le fer 64 dans sa position basse tout en déplaçant vers le haut le bras 82 comme l'illustre la figure 6g. Le déplacement relatif entre la pince 88 et l'extrémité libre du bras 82 qui résulte de la venue en butée de la butée 102 contre la butée 100 provoque l'ouverture de la pince 88 qui revient alors dans la position représentée sur la figure 5. La panne 64 du fer à souder est ensuite remontée comme l'illustre la figure 6h et une autre soudure peut être entreprise de la manière qui vient d'être décrite, en amenant la tête porte-outils 32 en vis-à-vis d'une autre pastille 22 afin de terminer l'interconnexion électrique dont la première soudure vient d'être décrite.

Bien entendu, le mode de réalisation de l'invention qui vient d'être décrit à titre d'exemple n'est nullement limitatif et l'invention en incorpore toutes les variantes.

On rappelle que dans la mise en œuvre de la présente invention l'ensemble des opérations est de préférence automatique, la machine comportant un programme de pilotage délivré par un calculateur.

### Revendications

1. Procédé de réalisation d'un circuit d'interconnexions électriques miniaturisées pour composants électroniques, dans lequel on utilise un support de base isolant (14) comportant des zones conductrices (12), on réunit les différentes zones conductrices à interconnecter par un fil isolé (10) en le collant sur le support de base, on soude le fil thermosoudable sur les zones conductrices et on le coupe après soudure, caractérisé en ce qu'on dépose du flux liquide sur les parties du fil à souder reposant sur les zones conductrices (12) avant de réaliser la soudure, afin de diminuer le temps de chauffage.

2. Procédé selon la revendication 1, caractérisé en ce que l'extrémité non soudée du fil (10) coupé est saisie et amenée sur une autre zone conductrice (12).

3. Procédé selon l'une quelconque des revendications 1 et 2, caractérisé en ce que lesdits composants étant des boîtiers électroniques (16) munis de deux séries de pattes (18) alignées et lesdites zones conductrices (12) étant groupées et alignées, et comprenant des pastilles (22) définissant chacune un plot de raccordement (24) susceptible de recevoir une patte (18) d'un boîtier, et une zone de soudage (28) de fil juxtaposée au plot de raccordement, le plot de raccordement et la zone de soudage de fils sont arrangés dans la direction définie par le groupe de zones conductrices correspondant, chaque pastille (22) étant découpée de façon à présenter une zone de largeur réduite jouant le rôle d'une résistance thermique entre le plot de raccordement (24) et la zone de soudage (28).

4. Procédé selon la revendication 3, caractérisé en ce que chaque pastille (22) est contenue dans un carré dont le côté est sensiblement égal aux 3/5 de la distance séparant le centre de deux zones conductrices (12) successives d'un même groupe, le plot de raccordement (24) et la zone de soudage (28) occupant dans ce carré deux rectangles juxtaposés dont les surfaces respectives sont sensiblement égales à 2/3 et 1/3 de la surface totale du carré.

5. Dispositif pour la réalisation d'un circuit d'interconnexions électriques pour composants électroniques, ayant pour fonction de relier par des fils isolés thermosoudables (10) des zones conductrices (12) situées sur un support de base (14) éventuellement recouvert de résine adhésive en dehors desdites zones conductrices, ce dispositif comprenant une table XY (60), le support de base isolant étant solidaire de ladite table, des moyens pour commander les translations de ladite table XY suivant les deux directions perpendiculaires, une tête (32) constituée d'un fût fixe (34) et d'un bâti rotatif (38) lié au fût, des moyens (40) pour commander la rotation du bâti autour d'un axe perpendiculaire au support, des moyens (50) solidaires du fût fixe pour dérouler un fil thermosoudable, et des moyens (52 à 58 ; 64 ; 86) solidaires du bâti rotatif pour appliquer le fil sur le support, souder le fil sur les zones conductrices et couper le fil après la soudure, les moyens (64) pour souder le fil constituant également des moyens pour dénuder le fil thermosoudable, caractérisé en ce qu'il comprend de plus des moyens (66 à 80) solidaires du bâti rotatif pour déposer sur le fil à souder reposant sur une zone conductrice une quantité déterminée de flux à souder.

6. Dispositif selon la revendication 5, caractérisé en ce que les moyens pour déposer une quantité déterminée de flux à souder comprennent un bras mobile (66) muni d'une extrémité recourbée (70) et un réservoir de flux (68) à niveau constant dans lequel l'extrémité recourbée du bras est au repos en contact permanent avec le flux (73).

7. Dispositif selon l'une quelconque des revendications 5 et 6, caractérisé en ce qu'il comprend de plus des moyens (88) pour saisir l'extrémité non soudée du fil coupé.

8. Dispositif pour la réalisation d'un circuit d'interconnexions électriques pour composants électroniques, ayant pour fonction de relier par des fils isolés (10) des zones conductrices (12) situées sur un support de base (14) éventuellement recouvert de résine adhésive en dehors desdites zones conductrices, ce dispositif comprenant une table XY (60), le support de base isolant étant solidaire de ladite table, des moyens pour commander les translations de ladite table XY suivant les deux directions perpendiculaires, une tête (32) constituée d'un fût fixe (34) et d'un bâti rotatif (38) lié au fût, des moyens (40) pour commander la rotation du bâti autour d'un axe perpendiculaire au support, des moyens (50) solidaires du fût fixe pour dérouler un fil isolé, et des moyens (52 à 58 ; 64 ; 86) solidaires du bâti rotatif pour appliquer le fil sur le support, souder le fil sur les zones conductrices et couper le fil après soudure, caractérisé en ce qu'il comprend de plus des moyens (88) pour saisir l'extrémité non soudée du fil coupé, associés aux moyens (86) pour couper le fil après soudure.

9. Dispositif selon l'une quelconque des revendications 8, caractérisé en ce que les moyens pour saisir l'extrémité non soudée du fil coupé comprennent une pince (88) et en ce que les moyens pour couper le fil comprennent un couteau (86), la pince étant portée par le couteau et étant munie d'une extrémité recourbée mobile dans une direction normale au support de base par rapport au couteau, le déplacement de l'extrémité recourbée de la pince par rapport au couteau commandant l'ouverture et la fermeture de la pince.

10. Dispositif selon la revendication 9, caractérisé en ce que l'extrémité recourbée de la pince (88) fait saillie au-delà du tranchant du couteau (86) lorsque la pince est ouverte, de telle sorte que la mise en œuvre du couteau entraîne la venue en butée de l'extrémité recourbée de la pince contre le support de base, puis le déplacement du couteau par rapport à l'extrémité de la pince dans le sens correspondant à la fermeture de celle-ci.

11. Dispositif selon l'une quelconque des revendications 9 et 10, caractérisé en ce que les moyens (64) pour souder le fil comprennent une butée (100) susceptible de venir affleurer une butée en vis-à-vis (102) formée sur la pince (88) lors de la mise en œuvre, de telle sorte que le déplacement du couteau (86) en éloignement du support de base entraîne la venue en butée de la pince contre la butée formée sur les moyens pour souder le fil, puis le déplacement du couteau par rapport à l'extrémité de la pince dans le sens correspondant à l'ouverture de celle-ci.

12. Dispositif selon l'une quelconque des revendications 9 et 11, caractérisé en ce que l'extrémité de la pince comprend deux mors en vis-à-vis (92) sollicités élastiquement en éloignement l'un de l'autre, et définissant sur leurs bords opposés des surfaces de came avec lesquelles coopèrent des doigts (96) fixés rigidement au couteau (86), la forme des surfaces de came étant telle que la pince est ouverte lorsque son extrémité fait saillie au-delà du tranchant du couteau et fermée lorsque son extrémité est sensiblement alignée avec le tranchant du couteau.

13. Dispositif selon la revendication 12, caractérisé en ce que la pince (88) est réalisée en un fil élastique préformé, tel qu'une corde à piano, replié en forme de U pour définir les mors (92) de la pince par ses deux extrémités en forme de losange, le fil élastique étant fixé au couteau (86) par sa partie médiane, les doigts (96) fixés au couteau coopérant avec les mors au voisinage de l'angle aigu du losange opposé à l'extrémité de la pince, lorsque celle-ci fait saillie au-delà du tranchant du couteau, et coopérant avec les mors au voisinage des angles obtus du losange, et du côté de l'extrémité de la pince, lorsque celle-ci est sensiblement alignée avec le tranchant du couteau.

**Claims**

1. A process for the formation of a circuit with miniaturized electric connections for electronic components, employing an insulating support (14) on which are conductive zones (12), different conductive zones to be linked being connected by an insulated wire (10) adhering to the support, the wire being soldered to the conductive zones, and cut after soldering, characterized in that a liquid flux is deposited on those parts of the wire to be soldered that lie on the conductive zones (12) before the formation of soldered joints, whereby to reduce the heating time.

2. A process according to Claim 1, characterized in that the non-soldered end of a cut wire (10) is held and is led to another conductive zone (12).

3. A process according to either of Claims 1 and 2, characterized in that said components are electronics packages (16) having two rows of aligned tabs (18), said conductive zones (12) being grouped and aligned, and comprising contact members (22), each comprising a contact zone (24), adapted to receive a respective tab (18) of a package, and a wire-soldering zone (28) juxtaposed to said contact zone, the contact zone and the wire-soldering zone being arranged in the direction defined by the group of corresponding conductive zones, each contact member (22) being cut away to provide a zone of reduced width acting as a heat barrier between the contact zone (24) and the wire-soldering zone (28).

4. A process according to Claim 3, characterized in that each contact member (22) is contained within a square outline whose side is substantially equal to 3/5 of the distance between the centres of two adjacent conductive zones (12) of the same group, the contact zone (24) and the wire-soldering zone (28) occupying, within said square, two juxtaposed rectangles whose areas are respectively substantially equal to 2/3 and 1/3 of the total area of the square.

5. An apparatus for forming a circuit of electric interconnections for electronic components, acting to link, by means of insulated solderable wires (10), conductive zones (12) situated on a support (14), optionally coated with an adhesive resin around said conductive zones, said apparatus comprising an XY table (60), the insulating support being fixable on said table, means for controllably moving said XY table in two perpendicular directions, a head (32) comprising a fixed shaft (34) and a rotatable frame (38) linked with the shaft, means (40) for rotating the frame around an axis perpendicular to the support, means (50) fixed with respect to the shaft for unreeling a solderable wire, and means (52-58 ; 64 ; 86), fixed with respect to the rotatable frame, for applying the wire to the support, for soldering the wire on the conductive zones, and for cutting the wire after soldering, the means (64) for soldering the wire also comprising means for stripping the solderable wire, characterized in that it additionally comprises means (66 to 80), fixed with respect to the rotatable frame, for depositing a predetermined amount of soldering flux on a part of the wire to be soldered that rests on a conductive zone.

6. An apparatus according to Claim 5, characterized in that the means for depositing a predetermined amount of soldering flux comprise a movable arm (66) having a bent end (70), and a constant-level flux reservoir (68) in which the bent end of the arm is in permanent contact with flux, when it is in its rest position.

7. An apparatus as claimed in either of Claims 5 and 6, characterized in that it additionally comprises means (88) for holding a non-soldered end of a cut wire.

8. An apparatus for forming a circuit of electric interconnections for electronic components, acting to link, by means of insulated solderable wires (10), conductive zones (12) situated on a support (14), optionally coated with an adhesive resin around said conductive zones, said apparatus comprising an XY table (60), the insulating support being fixable on said table, means for controllably moving said XY table in two perpendicular directions, a head (32) comprising a fixed shaft (34) and a rotatable frame (38) linked with the shaft, means (40) for rotating the frame around an axis perpendicular to the support, means (50) fixed with respect to the shaft for unreeling a solderable wire, and means (52-58 ; 64 ; 86), fixed with respect to the rotatable frame, for applying the wire to the support, for soldering the wire on the conductive zones, and for cutting the wire after soldering, characterized in that it additionally comprises means (88) for holding a non-soldered end of a cut wire, associated with means (86) for cutting the wire after soldering.

9. An apparatus according to Claim 8, characterized in that the means for holding the non-soldered end of a cut wire comprise a clip (88), and in that the means for cutting the wire comprise a blade (86), the clip being mounted on the blade and having a bent end which is movable with respect to the blade in a direction perpendicular to the support, motion of the bent end of the clip with respect to the blade commanding opening and closing of the clip.

10. An apparatus according to Claim 9, characterized in that the bent end of the clip (88) projects beyond the cutting edge of the blade (86) when the clip is open, whereby operation of the blade brings the bent end of the clip into abutment with the support, followed by displacement of the blade with respect to the end of the clip in the sense corresponding to closure of the latter.

11. An apparatus according to either of Claims 9 and 10, characterized in that the means (64) for soldering the wire comprise a stop (100) adapted to come into a contact with a facing stop (102) formed on the clip (88), during operation thereof, whereby displacement of the blade (86) away from the support brings the stop of the clip into abutment with the stop on the means for soldering the wire, and then displacement of the blade with respect to the end of the clip, in the sense corresponding to opening of the latter.

12. An apparatus according to either of Claims 9 and 11, characterized in that the end of the clip comprises two facing jaws (92) elastically urged away from one another, and defining, on their opposed sides, cam surfaces that cooperate with fingers (96) rigidly fixed to the blade (86), the form of the cam surfaces being such that the clip is open when its end projects beyond the cutting edge of the blade, and shut when its end is substantially aligned with the cutting edge of the blade.

13. An apparatus according to Claim 12, characterized in that the clip (88) is preformed from springy wire, such as piano wire, bent in U-form to define the jaws (92) of the clip at its two ends in the form of a lozenge, the middle part of the springy wire being fixed to the blade (86), the fingers (96) fixed to the blade cooperating with the jaws near the acute angle of the lozenge opposite the end of the clip when the latter projects beyond the cutting edge of the blade, and cooperating with the jaws near the obtuse angles of the lozenge and near the end of the clip, when the latter is substantially aligned with the cutting edge of the blade.

FIG.1

FIG.2

FIG. 3

# FIG.4

# FIG. 5

FIG.6a

FIG.6b

FIG.6c

FIG.6d

0 021 894

FIG.6e

FIG.6f

FIG.6g

FIG. 6h

0 021 894